Europäisches Patentamt

(19) European Patent Office

Office européen des brevets

(11) **EP 0 807 943 A1**

(12) **EUROPEAN PATENT APPLICATION**
published in accordance with Art. 158(3) EPC

(43) Date of publication:
19.11.1997 Bulletin 1997/47

(51) Int. Cl.$^6$: **H01G 4/06**

(21) Application number: 96901104.8

(86) International application number:
PCT/JP96/00123

(22) Date of filing: 24.01.1996

(87) International publication number:
WO 96/23312 (01.08.1996 Gazette 1996/35)

(84) Designated Contracting States:
DE NL

(30) Priority: 24.01.1995 JP 9204/95

(71) Applicant: KOMATSU LTD.
Minato-ku, Tokyo 107 (JP)

(72) Inventors:
• AOYAMA, Ikuto
Hiratsuka-shi, Kanagawa 254 (JP)

• SAKURAGI, Shunichi
Hiratsuka-shi, Kanagawa 254 (JP)

(74) Representative:
Selting, Günther, Dipl.-Ing. et al
Patentanwälte
von Kreisler, Selting, Werner
Postfach 10 22 41
50462 Köln (DE)

(54) **THIN-FILM BATTERY AND METHOD AND DEVICE FOR MANUFACTURING IT**

(57) A compact, light-weight battery having a high energy density, in which each dielectric thin film (10) is interposed between conductive films serving as electrodes (9) to store electrical energy. The thickness of the thin-film (10) is determined by the expression, $E \propto d^{2n-1}$, where E is the electrical energy, d is the thickness of the dielectric thin films, and the exponent (n) is no more than 0.5.

FIG.1(b)

FIG.1(a)

## Description

TECHNICAL FIELD

The present invention relates to a thin-film battery and a method and device for manufacturing a thin-film battery, and more particularly to a secondary battery.

BACKGROUND ART

Storage batteries are currently the most popular rechargeable batteries (secondary batteries), particular examples of which include lithium batteries, nickel batteries, and manganese batteries. A battery is a device that converts electrical energy to chemical energy for storage, and is composed of a combination of positive electrodes, active material/electrolyte/active material, and negative electrodes. Electron conducting materials are used for the positive and negative electrodes, ion conducting materials are used for the electrolyte, oxidation agents are used for the positive electrode active material, and reducing agents are used for the negative electrode active material.

All, however, feature the use of chemical reactions, making the solvent constituting the electrolyte indispensable. The solvent density is 0.7 to 1.6 g/cm$^3$, and this accounts for most of the battery volume and weight. Since the energy density of current secondary batteries is thus about 42 Wh/kg, a certain volume and weight is needed for the energy that is to be stored, making the volume and weight of the electrolyte a major issue in applications for electrical automobiles or solar cars. For example, when energy corresponding to 40 L of gasoline is stored, the fuel cell has a volume of 200 L and a weight of 400 kg, and must therefore occupy the rear seat or luggage compartment.

Efforts to store the same energy in conventional laminated types of ceramic capacitors have not solved the basic problem because the dielectric constant would be 10,000, the film thickness would be 1 $\mu$m, and the dielectric breakdown strength would be 10$^5$ V/cm, with an estimated volume of 20,000 L and a weight of $1.2 \times 10^5$ kg.

In view of the foregoing, an object of the present invention is to provide a compact, light-weight battery with dramatically higher energy density.

SUMMARY OF THE INVENTION

The first of the present inventions is a thin-film battery in which dielectric thin films are interposed between conductive films serving as electrodes to store electrical energy, characterized by comprising dielectric thin films having a thickness established by the following formula

$$E \propto d^{2n-1}$$

where E is the electrical energy that can be stored, d is the thickness of the dielectric thin films, and the exponent n is no more than 0.5.

A Ba$_{0.5}$Sr$_{0.5}$TiO$_3$ thin film or the like is preferably used for the dielectric thin films.

The dielectric thin film referred to here indicates one having the property of storing an electric charge when an electrical field is applied. Examples of dielectric thin films include Ba$_{0.5}$Sr$_{0.5}$TiO$_3$, SrTiO$_3$, and MgNbO$_3$, as well as Pb$_{0.99}$Nb$_{0.02}$((Zn$_{0.8}$Sn$_{0.4}$)$_{0.94}$Ti$_{0.06}$)$_{0.98}$O$_3$, Pb$_{0.97}$La$_{0.02}$Zr$_{0.66}$Sn$_{0.24}$Ti$_{0.10}$O$_3$, and other such antiferroelectric thin films.

The dielectric thin film is preferably characterized by comprising a multilayered structure of two or more laminated layers.

The thin-film battery is even more preferably characterized by comprising a multilayered structure of two or more layers laminated on the surface of a flat substrate.

The second of the present inventions is characterized by comprising: a cylindrical or columnar substrate; a four-layered laminate structure consisting of a first thin-film electrode, a first dielectric thin film, a second thin-film electrode, and a second dielectric thin film, spirally wound around the surface of the substrate; and first and second output electrodes attached to the first and second thin-film electrodes.

The substrate is preferably characterized by comprising a lanthanum strontium gallate (LaSrGaO$_4$) monocrystalline substrate.

The first and/or second thin-film electrode(s) are/is preferably characterized by comprising any of Bi$_2$Sr$_2$O$_{6-x}$ ($0 \leq x \leq 0.5$), Ca$_{1-x}$Sr$_x$RuO$_3$ ($0.4 \leq x \leq 0.6$), SrCrO$_3$, Er$_{1-x}$Nb$_x$O$_3$ ($0 \leq x \leq 0.3$), BaPbO$_3$, YBa$_2$Cu$_3$O$_7$, Nd$_{2-x}$Sr$_x$CuO$_4$ ($0.1 \leq x \leq 0.5$), La$_{2-x}$Sr$_x$CuO$_4$ ($0.1 \leq x \leq 0.5$), and Nb$_x$Sr$_{1-x}$TiO$_3$ ($0.0001 \leq x \leq 0.001$).

Here too, Ba$_{0.5}$Sr$_{0.5}$TiO$_3$ thin films, SrTiO$_3$, and MgNbO$_3$, as well as Pb$_{0.99}$Nb$_{0.02}$((Zn$_{0.8}$Sn$_{0.4}$)$_{0.94}$Ti$_{0.06}$)$_{0.98}$O$_3$, Pb$_{0.97}$La$_{0.02}$Zr$_{0.66}$Sn$_{0.24}$Ti$_{0.10}$O$_3$, and other such antiferroelectric thin films are effective as dielectric thin films.

The third of the present inventions is a method for manufacturing a thin-film battery, comprising the steps of: a battery-forming step for forming a thin-film battery by sequentially establishing at least first through fourth positions at prescribed intervals along the outer periphery of a cylindrical or columnar substrate as the substrate is rotated, so as to form a first thin-film electrode in the first position, a first dielectric thin film in the second position in the region where the first thin-film electrode has been formed, a second thin-film electrode in the third position in the region where the first dielectric thin film has been formed, and a second dielectric thin film in the fourth position in the region where the second thin-film electrode has been formed, these steps being such that the films are first formed sequentially at prescribed intervals of time and are subsequently continuously formed simultaneously, so that a four-layered laminate structure consisting of the first thin-film electrode, the first dielectric thin film, the second thin-film electrode, and the second dielectric thin film is spirally wound around the surface of the substrate; and an output electrode-forming step for forming first and second output electrodes on the first and second thin-film electrodes.

The fourth of the present inventions is characterized by comprising a vacuum vessel equipped with: a substrate support platform for rotatably supporting a cylindrical or columnar substrate; a cylindrical mask that has at least four slits formed parallel to the rotating shaft, and that is set up at a prescribed distance from the surface of the substrate; four targets for at least a first thin-film electrode, first dielectric thin film, second thin-film electrode, and second dielectric thin film, located in prescribed regions in the vacuum vessel corresponding to the four slits; and energy supply means for supplying energy rays to the targets, wherein particle beams scattered from the targets by the energy from the energy supply means pass through the slits of the mask and reach the substrate, resulting in the sequential formation of a four-layered laminate structure consisting of a first thin-film electrode, first dielectric thin film, second thin-film electrode, and second dielectric thin film spirally wound around the surface of the substrate.

The fifth of the present inventions is characterized in that the thickness d of the dielectric thin films is established so as to be no more than 3 times a critical thickness $d_c$ at which the dielectric constant is proportional to the thickness, and the thin-film battery has a laminated structure of at least 100 laminated layers.

Here too, $Ba_{0.5}Sr_{0.5}TiO_3$ thin films, $SrTiO_3$, and $MgNbO_3$, as well as $Pb_{0.99}Nb_{0.02}((Zn_{0.8}Sn_{0.4})_{0.94}Ti_{0.06})_{0.98}O_3$, $Pb_{0.97}La_{0.02}Zr_{0.66}Sn_{0.24}Ti_{0.10}O_3$, and other such antiferroelectric thin films are effective as dielectric thin films.

The electrostatic energy which is stored in the capacitor structure is given by the following formula.

$$E = 1/2 \cdot (\varepsilon_r \varepsilon_0 (S/d)) \cdot (F \cdot d)^2 \tag{1}$$

Where

E: energy that is stored
$\varepsilon_r$: dielectric constant of dielectric
$\varepsilon_0$: dielectric constant of vacuum
S: capacitor surface area
d: thickness of dielectric
F: electrical field applied to dielectric

There are thus two methods for increasing the energy density:

1. using a dielectric with a high dielectric constant; and
2. increasing the electrical field applied to the dielectric.

Here, the maximum voltage applied to the dielectric is given by the dielectric breakdown voltage of the dielectric, and the dielectric breakdown voltage is known to increase exponentially with respect to the inverse of the thickness of the dielectric.

The voltage applied to the capacitor can be increased because the dielectric breakdown voltage increases considerably when a capacitor is formed in this thickness region.

In a CGS unit system,

$$E(CGS) = (1/(2 \times 9 \times 10^{11}))(\varepsilon_r \varepsilon_0 (S/d)) \cdot (F \cdot d)^2 \tag{2}$$

Where

E: energy (J) that is stored
$\varepsilon_r$: dielectric constant of dielectric
$\varepsilon_0$: dielectric constant (=1) of vacuum
S: capacitor surface area ($cm^2$)
d: thickness of dielectric (cm)
F: electrical field applied to dielectric (V/cm)

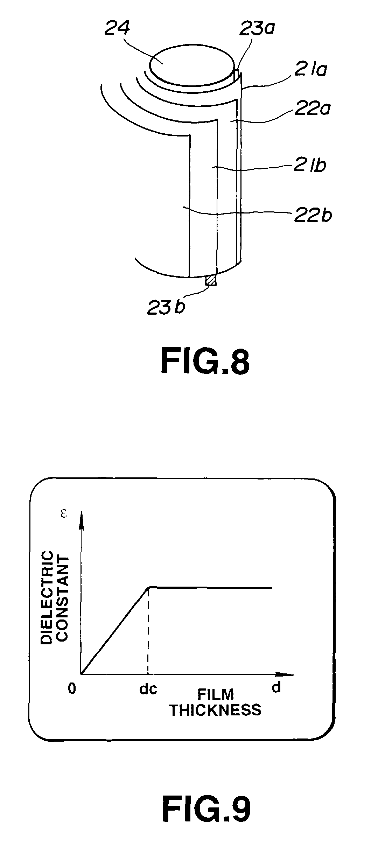

Here, the dielectric constant $\varepsilon_r$ of the dielectric is related as shown in Fig. 9 to the thickness of the dielectric. That is,

$$\varepsilon_r = \varepsilon_r \text{ (bulk) } d \geq d_c \tag{3}$$

$$\varepsilon_r = A \cdot d \quad d \leq d_c$$

The critical thickness $d_c$ differs depending on the material. A is a material constant.

The maximum electrical field applied to the dielectric is given by the dielectric breakdown strength $F_{max}$, except in the submicron thin film region.

$$F_{max} = B \cdot d^{(n-1)} \tag{4}$$

The coefficient B and exponent n (0.3 to 1) in this formula differ depending on the material.

When (3) and (4) are substituted for (2), the thickness dependency of the energy is given by the following formula.

$$E(CGS) = (1/(2 \times 9 \times 10^{11}))(\varepsilon_r(bulk)\varepsilon_0(B^2\delta \cdot d^{2n-1})) \quad d \geq d_c \tag{5}$$

$$= (1/2 \times 9 \times 10^{11}))(\varepsilon_0 A(B^2)\delta \cdot d^{2n})) \quad d \leq d_c \tag{6}$$

To determine the thickness dependency of the energy density stored in a capacitor, when N sets of laminated layers are made, assuming the electrode thickness is the same as the dielectric thickness, then

$$E(CGS)/gr = (1/(2 \times 9 \times 10^{11}))(\varepsilon_r(bulk)\varepsilon_0(B^2)(1/2\rho)d^{2n-2})) \quad d \geq d_c \tag{7}$$

$$= (1/2 \times 9 \times 10^{11}))(\varepsilon_0 A(B^2)(1/2\rho) \cdot d^{2n-1})) \quad d \leq d_c \tag{8}$$

Here, $\rho$ is the average density of the dielectrics and electrodes.

What is interesting is that $f(d)=d^{2n-2}$ increases as the thickness d decreases in $0.5 < n \leq 1$. That is, in Formula (7), the energy density increases up to the critical thickness $d_c$. At or below the critical thickness, according to Formula (8), the energy density decreases. However, when $n \leq 0.5$, $f(d)=d^{2n-1}$ increases as the thickness d decreases. This means that, when $n \leq 0.5$ in (7) and (8), the energy density increases in both cases.

In the case of submicron thin film regions, however, the dielectric constant of the dielectric is entirely the same as in Formula (3), but the dielectric breakdown strength $F_{max}$ begins to increase rapidly with decreases in the thickness of the thin film. This is also expressed by the exponential function of the thickness, but the exponent is different than that in Formula (4).

$$F_{max} = B' \cdot d^{n'-1} \tag{9}$$

The exponent n'-1 is usually negative. The dielectric breakdown voltage ($V_{max}$) is obtained by multiplying the film thickness.

$$V_{max} = B' \cdot d^{n'} \tag{10}$$

The exponent n' is also negative. When a thin-film capacitor is constructed in this film thickness region, the energy stored in the capacitor is greater the lower the thickness of the dielectric thin film. The film thickness dependency of the energy density at this time is similar to that in Formula (8).

$$E(CGS)/gr = (1/2 \times 9 \times 10^{11}))(\varepsilon_0 A(B \cdot {}^2)(1/2\rho) \cdot d^{2n-1})) \quad d \leq d_c \tag{11}$$

Thus, based on (8) and (11), the dielectric breakdown voltage is exponentially dependent on the thickness of the dielectric, and this exponent should essentially be no more than 0.5, in order to increase the energy density of a thin-film capacitor.

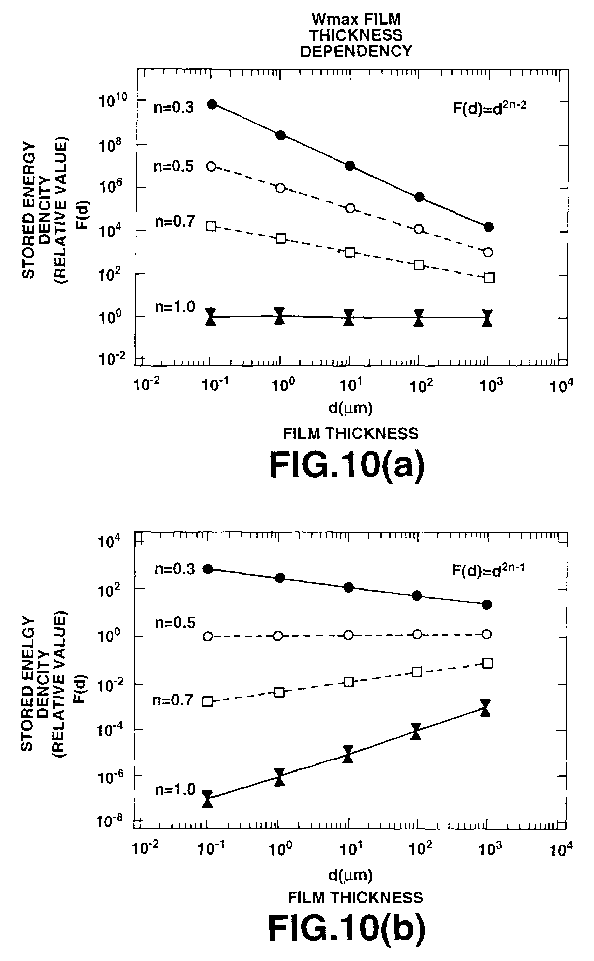

Fig. 10(a) and (b) are graphs plotting the calculated $F(d) = d^{2n-2}$ and $F(d) = d^{2n-1}$. When $d \geq d_c$, the maximum stored energy density of a capacitor is increased simply by lowering the film thickness, but when $d \leq d_c$, depending on the selection of the exponent n, lowering the film thickness sometimes does not result in an increase in stored energy density, so the selection of the exponent n (the selection of a material having the exponent n) is important in order to increase the stored energy density with a compact size.

It may thus be seen that, when the exponent is no more than 0.5, the thinner the dielectric thickness the greater the energy density. Since a reduction in the dielectric thickness also results in a lower capacitor volume, even laminated structures of 100 layers or more allow the energy that is stored to be dramatically increased without increasing the size. However, since the dielectric breakdown voltage decreases dramatically depending on the dielectric grain boundary and the like, it is important to enhance the performance by the heteroepitaxial formation of the dielectric thin films and thin-film electrodes. Additionally, tunnel current can no longer be disregarded as the dielectric thickness decreases, so tunnel current should be reduced by minimizing the overlap of wave functions as a result of combinations of different types of Fermi surface wave functions governing the electric conduction of the pairs of metal or conductive oxide thin-film electrodes sandwiching the thin films of high dielectric materials.

In the first of the present inventions, the dielectric thin films have a thinness that cannot be realized in ceramic capacitors, allowing multiple layers to be made with low surface area and the stored energy density to be dramatically decreased.

The thin-film battery has a multilayered structure with two or more laminated layers, allowing the stored electrical energy to be greatly increased.

The thickness of the dielectric thin films should be no more than 5 $\mu$m, and even more preferably between 0.1 and 1 $\mu$m. The critical film thickness of the various dielectric thin films is no more than 5 $\mu$m and is used at or below this film thickness. A large-capacity thin-film battery with a high stored energy efficiency can be obtained by laminating thin-film batteries of 100 layers or more.

In the second of the present inventions, the dielectric thin film material and thickness are selected in accordance with the aforementioned conditions, and a four-layered laminate consisting of a first dielectric thin film, first thin-film electrode, second dielectric thin film, and second thin-film electrode is formed and is spirally wound around the surface of a cylindrical or columnar substrate, so as obtain an extremely compact thin-film battery with substantial stored energy.

The substrate is preferably made of a lanthanum-strontium gallate ($LaSrGaO_4$) monocrystalline substrate, allowing the lattice constant to be made closer to that of the thin-film electrodes, allowing epitaxial growth to be achieved, and allowing the orientation to be enhanced and stored energy loss to be minimized.

The first and/or second thin-film electrodes are preferably formed of any of $Ca_{1-x}Sr_xRuO_3$ ($0.4 \leq x \leq 0.6$), $SrCrO_3$, $Er_{1-x}Nb_xO_3$ ($0 \leq x \leq 0.3$), $BaPbO_3$, $YBa_2Cu_3O_7$, $Nd_{2-x}Sr_xCuO_4$ ($0.1 \leq x \leq 0.5$), $La_{2-x}Sr_xCuO_4$ ($0.1 \leq x \leq 0.5$), and $Nb_xSr_{1-x}TiO_3$ ($0.0001 \leq x \leq 0.001$), allowing the lattice constant to be made closer to that of the substrate to obtain thin-film electrodes with better orientation. The first and second thin-film electrodes may also be made of different materials on the positive and negative electrode sides.

In the third and fourth of the present inventions, multilayered films are continuously formed in sequence to form laminated films with extreme ease in spiral form. The thickness of each layer can be regulated with extreme ease by regulating the rotating speed of the substrate support platform and the amount of energy supplied, allowing large-capacity thin-film batteries to be formed.

In the fifth of the present inventions, a large-capacity thin-film battery can be formed using dielectric thin films having a thickness no more than 3 times the critical film thickness.

An externally attached circuit is needed to extract current at a fixed voltage in thin-film batteries in which $Ba_{0.5}Sr_{0.5}TiO_3$, $MgNbO_3$, or the like is used as the dielectric thin film, but since it is possible to extract a charge only at a constant voltage with antiferroelectric thin films, the voltage is necessarily constant, making such a circuit unnecessary when batteries are manufactured using antiferroelectric thin films.

BRIEF DESCRIPTION OF THE DRAWINGS

Fig. 1 depicts a first example of the thin-film battery in the present invention;
Fig. 2 depicts a manufacturing device for forming the same thin-film battery;
Fig. 3 depicts a second example of the thin-film battery in the present invention;
Fig. 4 depicts a manufacturing device for forming the same thin-film battery;
Fig. 5 is an illustration of the same device;
Fig. 6 illustrates the process for forming the same thin-film battery;
Fig. 7 is an illustration of the same device;
Fig. 8 is an illustration of the main parts of the same thin-film battery;
Fig. 9 is an illustration of the critical thickness to describe the present invention; and
Fig. 10 is an illustration of the principles of the present invention.

BEST MODE FOR CARRYING OUT THE INVENTION

Examples of the present invention are described in detail below with reference to the drawings.

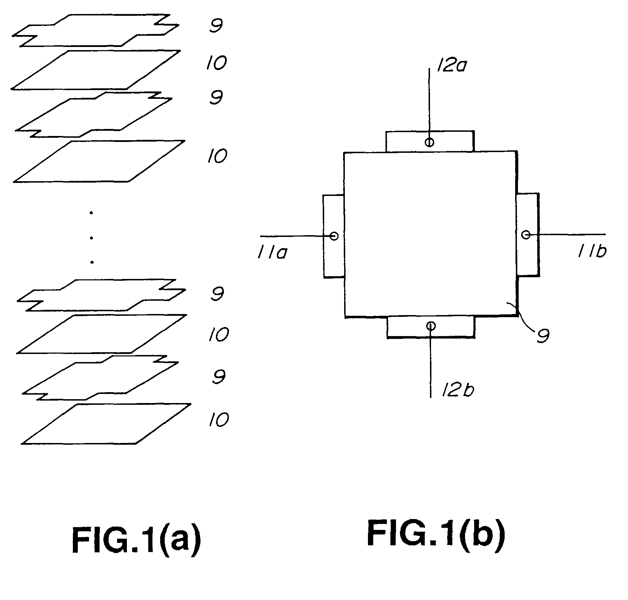

As shown in the exploded view Fig. 1(a) and the elevation Fig. 1(b), the thin-film battery is made by alternately laminating $10^6$ times 0.1 $\mu$m thick $Nd_{1.5}Ce_{0.5}CuO_4$ thin films as thin-film electrodes 9 and 0.1 $\mu$m thick $Ba_{0.5}Sr_{0.5}TiO_3$ thin films 10 as the dielectric thin films on the surface of a strontium titanate ($SrTiO_3$) substrate 8, wherein the uppermost layer is used as a thin-film electrode 9, an electrical connection is made through output electrodes 11a and 12a, and the batteries are connected in series.

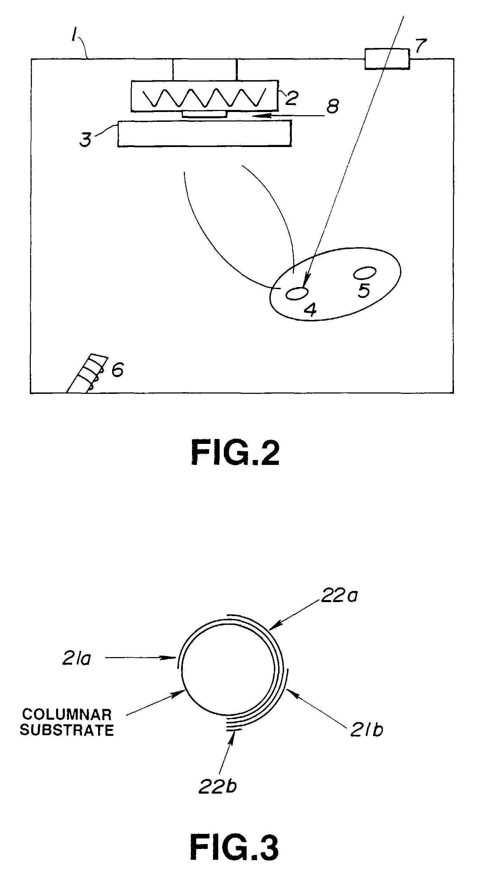

During the manufacture of the thin-film battery, a substrate holder 2 equipped with a heater is formed in a vacuum chamber 1 as shown in Fig. 2, and a device that is equipped with a mask exchange mechanism 3 with two types of masks for forming dielectric thin films and thin-film electrodes, a first target 4 consisting of the dielectric material and a second target 5 consisting of the electrode material, and an oxygen plasma gun 6 for radiating oxygen plasma onto the substrate 8 to be treated on the substrate holder 2 is used. A transmitting window 7 though which ultraviolet rays are transmitted is formed in the vacuum chamber 1, and light is guided from an ultraviolet ray laser on the outside of the vacuum chamber 1 onto the targets. Here, a movable mirror is used to adjust the laser light so that it selectively reached the targets 4 and 5 in sequence. Here, the laser light is 1 $J/cm^2$, the repeating frequency is 10 Hz, and the substrate holder temperature is 700°C.

The 1.6 cm long × 6.5 cm wide strontium titanate ($SrTiO_3$) substrate 8 is placed on the substrate holder 2 of the device, a mask for forming a thin-film electrode is selected by the mask exchange mechanism 3, and laser light is radiated onto the first target 4. At this time, clusters, ions, molecules, and electrons are scattered from the target surface, resulting in the formation of an $Nd_{1.5}Ce_0Cu_5O_4$ thin film as a thin-film electrode 9. Oxygen plasma (oxygen flow rate of 0.1 L/min, high frequency power of 50 W) is irradiated from the oxygen plasma gun 6 to smooth the surface of the thin-film electrode 9. This process results in a centerline mean roughness Ra of 0.5 nm.

A mask for forming a dielectric thin film is then selected by the mask exchange mechanism 3, and laser light is radiated onto the second target 5. A 0.1 μm thick $Ba_{0.5}Sr_{0.5}TiO_3$ thin film is thus formed as a dielectric thin film 10, and oxygen plasma (oxygen flow rate of 0.1 L/min, high frequency power of 50 W) is again irradiated to smooth the surface of the dielectric thin film 10. This process results in a centerline mean roughness Ra of 0.5 nm.

These processes are alternately repeated $10^6$ times to laminate the layers, the uppermost layer is used as the thin-film electrode 9, an electrical connection is formed through output electrodes 11a and 12a as shown in Fig. 2, and a laminated capacitor type of thin-film battery is thus completed.

When the thin-film battery thus formed is charged with 100 V, $5 \times 10^8$ J (= $1.4 \times 10^5$ Wh) energy can be stored. This energy corresponds to 40 L of gasoline for a gasoline automobile. The external battery volume is 10 cm × 10 cm × 20 cm, the weight is 12 kg, and the energy density is $1.2 \times 10^4$ Wh/kg, which is 280 times that of normal storage batteries.

A 1.6 cm long × 6.5 cm wide battery manufactured by laminating $3 \times 10^4$ layers of dielectric layers according to the same method has a volume of 1.6 cm × 6.5 cm × 0.6 cm and stored energy of 570 Wh when charged with 100 V, which is about 800 times the energy that is stored in conventional Ni-Cd batteries of the same size when charged with 1.2 V.

A laminated type of structure was given in the foregoing example, but the invention can also be adapted to thin-film batteries having single-layer structures, and since this is an extremely thin type of battery, a thin-film electrode, dielectric thin film, and thin-film electrode can be laminated via a buffer layer and integrated with the reverse side of a movable terminal.

A second example of the present invention is described below.

As shown in cross section Fig. 3, this thin-film battery is made by spirally forming a four-layered laminate consisting of a 0.1 μm thick $Nb_xSr_{1-x}TiO_3$ thin film electrode 21a, a 0.1 μm thick $Ba_{0.5}Sr_{0.5}TiO_3$ dielectric thin film 22a, a 0.1 μm thick $Nb_xSr_{1-x}TiO_3$ thin film electrode 21b, and a 0.1 μm thick $Ba_{0.5}Sr_{0.5}TiO_3$ dielectric thin film 22b around the surface of a cylindrical lanthanum-strontium gallate ($LaSrGaO_4$) substrate 16.

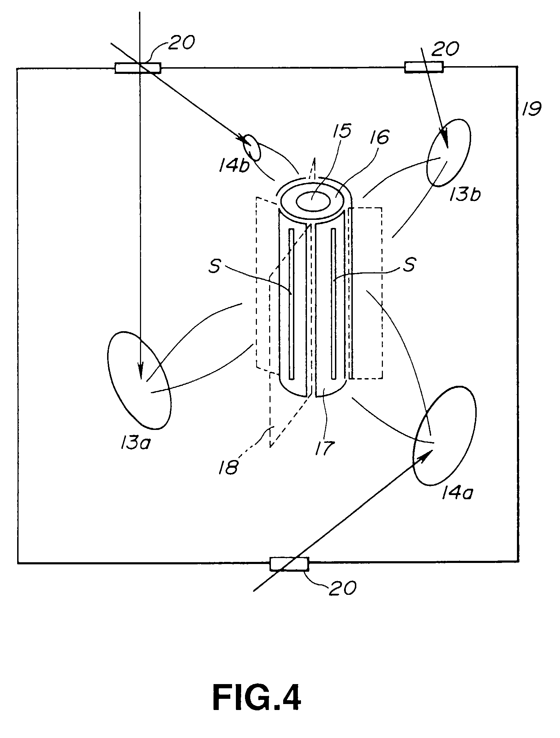

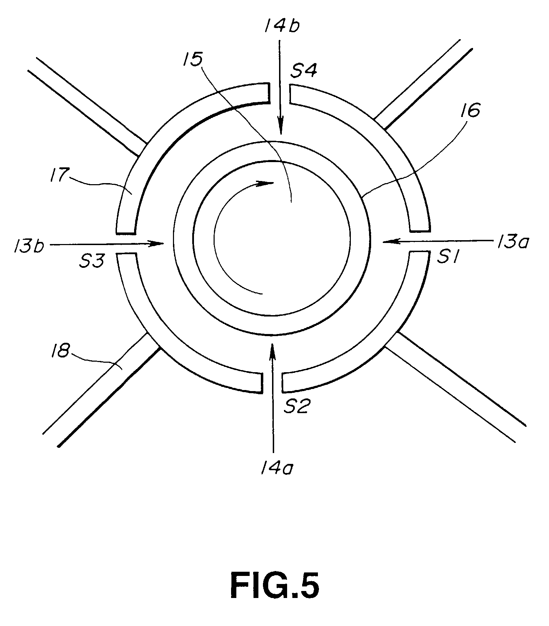

During the manufacture of the thin-film battery, a rotatable cylindrical substrate holder 15 equipped with a heater is located in a vacuum chamber 19 as shown in Fig. 4, a roll-shaped substrate 16 is placed on the substrate holder 15, a cylindrical mask 17 having 4 slits S is placed in a location at a prescribed distance from the surface of the substrate 16, and a device equipped with first targets 13a and 13b consisting of $Nb_xSr_{1-x}TiO_3$ ($0.0001 \leq x \leq 0.001$) as the electrode material and second targets 14a and 14b consisting of $Ba_{0.5}Sr_{0.5}TiO_3$ as the dielectric material and $Nb_xSr_{1-x}TiO_3$ ($0.0001 \leq x \leq 0.001$) as the electrode material is used. 18 is a barrier for preventing clusters, molecules, and the like from being scattered from the first and second targets. A transmitting window 20 though which ultraviolet rays are transmitted is formed in the vacuum chamber 19, and light is guided from an ultraviolet ray laser on the outside of the vacuum chamber 19 onto the targets. Here, targets 13a, 13b, 14a, and 14b are irradiated with laser light, but the initial irradiation can be shifted in set increments of time. Here, the mask 17 has slits S1 through S4 parallel to the rotating shaft in four locations, and the slit width is adjusted according to the rotating speed of the substrate holder 15. As shown in Fig. 5, the first thin-film electrode and first dielectric film and the second thin-film electrode and second dielectric thin film are sequentially formed in their respective locations by the particles transmitted through the slits S1 through S4, and are thus alternately laminated continuously in spiral form around the surface of the rotating substrate. Here, the laser light is 1 J/cm2, the repeating frequency is 10 Hz, and the substrate holder temperature is 700°C.

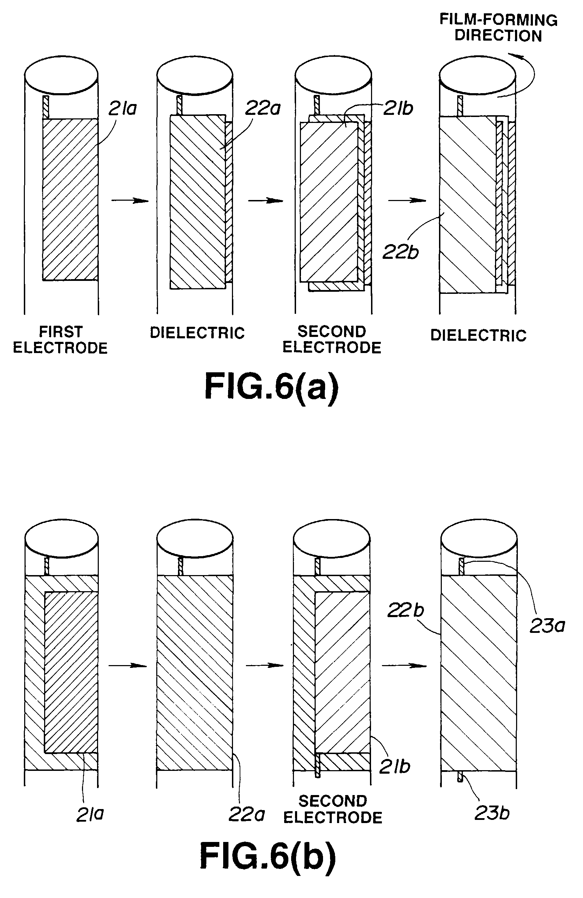

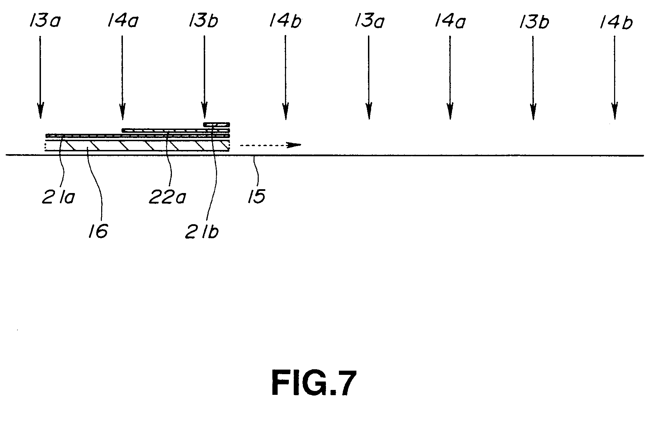

The cylindrical lanthanum-strontium gallate ($LaSrGaO_4$) substrate 16 is placed on the substrate holder 15 of the device, the mask 17 and barrier 18 are set up, the substrate holder 15 is then rotated at a prescribed rotating speed, and the first target 13a begins to be irradiated with laser light first. At this time, clusters, ions, molecules, or electrons are scattered from the target surface and reach the substrate surface through the slit S1, and a 0.1 μm thick $Nb_xSr_{1-x}TiO_3$ thin film begins to be formed as the thin-film electrode 21a. Slightly later, when the beginning end of the dielectric thin film 21a reaches the location of the slit S2, the second target 14a begins to be irradiated with laser light. At this time,

a 01 μm thick $Ba_{0.5}Sr_{0.5}TiO_3$ thin film begins to be formed as the dielectric thin film 22a. Slightly later, when the beginning end of the thin-film electrode 22a reaches the location of the slit S3, the first target 13b begins to be irradiated with laser light. At this time, a 0.1 μm thick $Nb_xSr_{1-x}TiO_3$ thin film is formed as the thin-film electrode 21b. Slightly later, when the beginning end of the thin-film electrode 21b reaches the location of the slit S4, the second target 14b begins to be irradiated with laser light. At this time, a 0.1 μm thick $Ba_{0.5}Sr_{0.5}TiO_3$ thin film begins to be formed as the dielectric thin film 22b. Thin films are thus laminated in sequence by the continuing supply of clusters, atoms, or molecules from the slits (Fig. 6 is an illustration of the process; Fig. 6(a) illustrates the beginning of the process, and Fig. 6(b) illustrates the final process). Fig. 7 is a plan illustrating this. That is, as the substrate surface travels, each thin film is produced in successive zones. As shown in cross section Fig. 3, a four-layered laminate consisting of the thin-film electrode 21a, dielectric thin film 22a, thin-film electrode 21b, and dielectric thin film 22b is thus formed in a spiral.

Finally, as shown in Fig. 8 (the top film is omitted to elucidate the electrode output region), output electrodes 23a and 23b are attached to the thin-film electrodes 21a and 21b so as to complete the thin-film battery.

In the foregoing example, the films were sequentially formed as the substrate was rotated, but the substrate may be composed of a thin insulating film; a three-layered film consisting of a thin-film electrode, dielectric thin film, and thin-film electrode may be continuously formed in sequence as the film is wound from a feed roll serving as a substrate holder onto a winding roll (a roll is formed while laminated, in the same manner as shown in Fig. 7); and a thin-film battery in the form of a spiral similar to that depicted in Fig. 3 may be obtained.

A thin-film battery consisting of multilayered films can thus be formed with extreme ease.

The film thickness can be readily adjusted here too by adjusting the substrate rotating speed and the energy supplied to the targets.

Suitable materials other than those used in the foregoing examples can be used as the electrode material and dielectric thin film material.

To improve the junction surface between the substrate and thin-film electrodes, materials with similar lattice constants may be selected or a layer of graduated composition may be interposed to alleviate differences in lattice constant. Because the dielectric constant differs depending on the axial direction of the crystals, dielectrics may be epitaxially grown in the direction in which the dielectric constant is greater.

<u>INDUSTRIAL APPLICABILITY</u>

The present invention allows a compact battery with high energy density to be provided.

**Claims**

1. A thin-film battery in which dielectric thin films are interposed between conductive films serving as electrodes to store electrical energy, characterized in that the dielectric thin films have a thickness established by the following formula

$$E \propto d^{2n-1}$$

   where E is the electrical energy that can be stored, d is the thickness of the dielectric thin films, and the exponent n is no more than 0.5.

2. A thin-film battery as defined in Claim 1, characterized in that the thin-film battery comprises a multilayered structure of two or more laminated layers.

3. A thin-film battery as defined in Claim 1, characterized in that the thin-film battery comprises a multilayered structure of two or more layers laminated on the surface of a flat substrate.

4. A thin-film battery as defined in any of Claims 1 through 3, characterized in that the dielectric thin films are antiferroelectric thin films.

5. A thin-film battery, characterized by comprising:

   a cylindrical or columnar substrate;
   a four-layered laminate structure consisting of a first thin-film electrode, a first dielectric thin film, a second thin-film electrode, and a second dielectric thin film, spirally wound around the surface of the substrate; and
   first and second output electrodes attached to the first and second thin-film electrodes, wherein the dielectric thin films have a thickness established by the following formula

$$E \propto d^{2n-1}$$

where E is the electrical energy that can be stored, d is the thickness of the first and second dielectric thin films, and the exponent n is no more than 0.5.

6. A thin-film battery as defined in Claim 5, characterized in that the substrate is a lanthanum strontium gallate ($LaSrGaO_4$) monocrystalline substrate.

7. A thin-film battery as defined in Claim 5, characterized in that the first and/or second thin-film electrode(s) comprise(s) any of $Bi_2Sr_2O_{6-x}$ ($0 \le x \le 0.5$), $Ca_{1-x}Sr_xRuO_3$ ($0.4 \le x \le 0.6$), $SrCrO_3$, $Er_{1-x}Nb_xO_3$ ($0 \le x \le 0.3$), $BaPbO_3$, $YBa_2Cu_3O_7$, $Nd_{2-x}Sr_xCuO_4$ ($0.1 \le x \le 0.5$), $La_{2-x}Sr_xCuO_4$ ($0.1 \le x \le 0.5$), and $Nb_xSr_{1-x}TiO_3$ ($0.0001 \le x \le 0.001$).

8. A thin-film battery as defined in any of Claims 5 through 7, characterized in that the dielectric thin films are antiferroelectric thin films.

9. A method for manufacturing a thin-film battery, characterized by comprising:

a battery-forming step for forming a thin-film battery by sequentially establishing at least first through fourth positions at prescribed intervals along the outer periphery of a cylindrical or columnar substrate as the substrate is rotated, so as to form a first thin-film electrode in the first position, a first dielectric thin film in the second position in the region where the first thin-film electrode has been formed, a second thin-film electrode in the third position in the region where the first dielectric thin film has been formed, and a second dielectric thin film in the fourth position in the region where the second thin-film electrode has been formed, these steps being such that the films are first formed sequentially at prescribed intervals of time and are subsequently continuously formed simultaneously, so that a four-layered laminate structure consisting of the first thin-film electrode, the first dielectric thin film, the second thin-film electrode, and the second dielectric thin film is spirally wound around the surface of the substrate; and
an output electrode-forming step for forming first and second output electrodes on the first and second thin-film electrodes.

10. A device for manufacturing a thin-film battery, characterized by comprising:

in a vacuum vessel,
a substrate support platform for rotatably supporting a cylindrical or columnar substrate;
a cylindrical mask that has at least four slits formed parallel to the rotating shaft, and that is set up at a prescribed distance from the surface of the substrate;
four targets for at least a first thin-film electrode, first dielectric thin film, second thin-film electrode, and second dielectric thin film, located in prescribed regions in the vacuum vessel corresponding to the four slits; and
energy supply means for supplying energy rays to the targets,
wherein particle beams scattered from the targets by the energy from the energy supply means pass through the slits of the mask and reach the substrate, resulting in the sequential formation of a four-layered laminate structure consisting of a first thin-film electrode, first dielectric thin film, second thin-film electrode, and second dielectric thin film spirally wound around the surface of the substrate.

11. A thin-film battery in which dielectric thin films are interposed between conductive films serving as electrodes to store electrical energy, characterized in that the thickness d of the dielectric thin films is established so as to be no more than 3 times a constant critical thickness $d_c$ at which the dielectric constant is proportional to the thickness and is constant beyond that value, and the thin-film battery has a laminated structure of at least 100 laminated layers.

12. A thin-film battery as defined in Claim 11, characterized in that the dielectric thin films are antiferroelectric thin films.

FIG.1(a)

FIG.1(b)

# FIG.2

# FIG.3

# FIG.4

FIG.5

FILM-FORMING
DIRECTION

*2la*  *22a*  *2lb*  *22b*

FIRST
ELECTRODE  DIELECTRIC  SECOND
ELECTRODE  DIELECTRIC

## FIG.6(a)

*22b*  *23a*

*2lb*

*2la*  *22a*  SECOND
ELECTRODE  *23b*

## FIG.6(b)

13a     14a     13b     14b     13a     14a     13b     14b

21a     22a     15

16     21b

# FIG.7

24    23a
21a
22a
21b
22b
23b

# FIG.8

ε

DIELECTRIC CONSTANT

0        dc        FILM
                  THICKNESS        d

# FIG.9

**Wmax FILM THICKNESS DEPENDENCY**

FILM THICKNESS

# FIG.10(a)

FILM THICKNESS

# FIG.10(b)

## INTERNATIONAL SEARCH REPORT

International application No.

PCT/JP96/00123

**A.  CLASSIFICATION OF SUBJECT MATTER**

Int. Cl$^6$  H01G4/06

According to International Patent Classification (IPC) or to both national classification and IPC

**B.  FIELDS SEARCHED**

Minimum documentation searched (classification system followed by classification symbols)

Int. Cl$^6$  H01G4/06

Documentation searched other than minimum documentation to the extent that such documents are included in the fields searched

| | |
|---|---|
| Jitsuyo Shinan Koho | 1926 – 1996 |
| Kokai Jitsuyo Shinan Koho | 1971 – 1996 |

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| X | JP, 5-326839, A (Toshiba Corp.),<br>December 10, 1993 (10. 12. 93)(Family: none) | 1 |
| Y | JP, 5-326839, A (Toshiba Corp.),<br>December 10, 1993 (10. 12. 93)(Family: none) | 2, 3 |
| Y | JP, 55-052213, A (Siemens AG.),<br>April 16, 1980 (16. 04. 80)<br>& EP, 9806, A1 & US, 4376329, A<br>& DE, 2843581, C2 | 2, 3 |
| X | JP, 5-166666, A (Toshiba Corp.),<br>July 2, 1993 (02. 07. 93)(Family: none) | 11 |
| A | JP, 2-43042, A (Spectrum Control, Inc.),<br>February 13, 1990 (13. 02. 90)(Family: none) | 4-10, 12 |

☐  Further documents are listed in the continuation of Box C.      ☐  See patent family annex.

* Special categories of cited documents:
"A"  document defining the general state of the art which is not considered to be of particular relevance
"E"  earlier document but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

| Date of the actual completion of the international search | Date of mailing of the international search report |
|---|---|
| April 19, 1996 (19. 04. 96) | April 30, 1996 (30. 04. 96) |

| Name and mailing address of the ISA/ | Authorized officer |
|---|---|
| Japanese Patent Office | |
| Facsimile No. | Telephone No. |

Form PCT/ISA/210 (second sheet) (July 1992)

17